# EUROPEAN PATENT SPECIFICATION

(11) **EP 3 065 237 B1**
(45) Date of publication and mention of the grant of the patent: **06.05.2020**
(21) Application number: 15157905.9
(22) Date of filing: 06.03.2015
(51) Int. Cl.: H01S 5/10, H01S 5/14, G02B 6/122

(54) **A TEMPERATURE INSENSITIVE LASER**
TEMPERATURUNEMPFINDLICHER LASER
LASER INSENSIBLE À LA TEMPÉRATURE

(43) Date of publication of application: 07.09.2016
(73) Proprietor: Caliopa NV, 9052 Zwijnaarde (BE)
(72) Inventor: Tassaert, Martijn, 80992 Munich (DE); Lamponi, Marco, 80992 Munich (DE); Collins, Tom, 80992 Munich (DE)
(74) Representative: Kreuz, Georg Maria

(56) References cited:
- JP-A- 2011 253 930
- JOCK BOVINGTON ET AL: "Athermal laser design", OPTICS EXPRESS, vol. 22, no. 16, 4 August 2014 (2014-08-04), page 19357, XP055207104, DOI: 10.1364/OE.22.019357
- QIU FENG ET AL: "Complementary metal-oxide-semiconductor compatible athermal silicon nitride/titanium dioxide hybrid micro-ring re", APPLIED PHYSICS LETTERS, AMERICAN INSTITUTE OF PHYSICS, US, vol. 102, no. 5, 4 February 2013 (2013-02-04), pages 51106-51106, XP012169120, ISSN: 0003-6951, DOI: 10.1063/1.4790440 [retrieved on 2013-02-06]
- J. T. BOVINGTON ET AL: "Role of thermal stress in athermal waveguide design using TiO<inf>2</inf> waveguides on a silicon substrate", 2013 IEEE PHOTONICS CONFERENCE, 1 September 2013 (2013-09-01), pages 219-220, XP055207096, DOI: 10.1109/IPCon.2013.6656513 ISBN: 978-1-45-771506-8
- FENG QIU ET AL: "Athermal and High-Q Hybrid TiO 2 -Si 3 N 4 Ring Resonator via an Etching-Free Fabrication Technique", ACS PHOTONICS, vol. 2, no. 3, 25 February 2015 (2015-02-25), pages 405-409, XP055207107, ISSN: 2330-4022, DOI: 10.1021/ph500450n

## Description

### TECHNICAL FIELD

The present invention relates to a temperature insensitive, i.e. athermal, laser. In particular, the present invention relates to a temperature insensitive semiconductor laser.

### BACKGROUND

Silicon photonics is rapidly gaining importance as a generic technology platform for a wide range of applications, such as broadband sensors, lasers for fiber optic communications networks and the like. Silicon photonics allows implementing photonic functions through the use of CMOS compatible wafer-scale technologies on high quality, low cost silicon substrates. However, pure passive silicon waveguide devices still have limited performance in terms of insertion loss, phase noise, which results in channel crosstalk, and temperature dependency. This is due to the high refractive index contrast between the silicon dioxide cladding and the silicon core, the non-uniform silicon layer thickness and the large thermo-optic effect of silicon.

Today a large part of the cost of photonic components comes from the packaging, rather than the die cost. This is particularly true if the temperature of the chip needs to be accurately controlled and a thermo-electric cooler (TEC) is included in the component design. A TEC requires a hermetic environment and components using them are typically enclosed in a "gold-box" housing. For photonics to become the dominant link technology even over short distances, say metres, the technology has to be cost competitive with copper solutions. This will require low-cost packaging techniques, such as photonic chips mounted directly on a printed circuit board, and certainly rules out the use of a TEC.

Today for uncooled lasers for optical communication applications the channel spacing for Coarse Wavelength Division Multiplex (CWDM) is set at 20 nm. This is because, without a TEC, the laser wavelength will drift as a function of temperature. It is extremely difficult to design photonics functions that work over more than 80 to 100 nm. Therefore only four wavelength channels are available for CWDM applications. As Ethernet data links move to 400 Gbps and beyond four wavelength channels no longer suffice. For instance, one proposal is to use PAM-4 to get 50 Gbps per channel using 25 Gbps technology and 8 wavelength channels.

If a cost effective athermal laser would be available the CWDM channel spacing could be reduced to 10 nm and a 8-channel CWDM, uncooled solution becomes possible.

There is, therefore, a need for a substantially temperature insensitive laser, i.e. a laser with a substantially temperature independent emission wavelength.

JOCK BOVINGTON ET AL: "Athermal laser design", OPTICS EXPRESS, vol.22, no.16, page 19357 discloses circuit based and waveguide based athermalization schemes and provides some design examples of athermalized lasers utilizing fully integrated athermal components as an alternative to power hungry thermo-electric controllers (TECs), off-chip wavelength lockers or monitors with lookup tables for tunable lasers. The principle is that the cavity mode thermal drift is managed by cavity design in which the length of a waveguide section with a negative thermo-optic coefficient is appropriately weighted with the sections of the laser that have a positive thermo-optic coefficient, such as the semiconductor gain region. In particular, a Si waveguide with TiO₂ cladding is used.

JP 2011 253930 A discloses a semiconductor optical device comprises a semiconductor optical amplifier and an optical wavelength selection element. The optical wavelength selection element includes a first light waveguide and a ring resonator that is optically connected to a coupling waveguide of the first light waveguide. Additionally, the optical wavelength selection element includes a second light waveguide including a coupling waveguide that is optically connected to the ring resonator, and a wavelength selection reflector is formed in the second light waveguide. The wavelength selection reflector is composed of a vertical diffraction grating, and reflects light having a wavelength of the peak of one resonance mode in the peaks of the resonance modes selected by the ring resonator.

QIU FENG ET AL: "Complementary metal - oxide - semiconductor compatible athermal silicon nitride/titanium dioxide hybrid micro-ring resonators", 2013 IEEE PHOTONICS CONFERENCE, 1 September 2013, page 219-220 discloses a complementary metal-oxide-semiconductor compatible athermal micro-ring resonator made from titanium dioxide (TiO2) and silicon nitride (SiNx).

### SUMMARY

It is an object of the invention to provide a substantially temperature insensitive laser.

This object is achieved by the subject matter of the independent claim. Further implementation forms are provided in the dependent claims, the description and the figures.

According to a first aspect, the invention relates to a semiconductor laser, comprising a gain region for generating laser radiation, a reflector region for reflecting the laser radiation generated in the gain region, and a waveguide for guiding the laser radiation generated in the gain region to the reflector region and/or within the reflector region and for guiding the laser radiation reflected in the reflector region to the gain region and/or within the gain region, wherein the gain region, the reflector region and the waveguide define a resonating cavity of the semiconductor laser, wherein the waveguide (105; 405) comprises a waveguide layer (219) and a compensation layer (221) arranged above the waveguide layer (219), wherein the semiconductor laser further comprising a planarising oxide layer (227) arranged between the waveguide layer (219) and the compensation layer (221), wherein the compensation layer (221) comprises a material with a refractive index in the range from about 1.8 to about 2.5 and a negative temperature coefficient in the range from -0.5 x 10⁻⁴ to -2 x 10⁻⁴ per °C, wherein the waveguide layer (219) comprises silicon nitride, wherein a thickness of the compensation layer (221) is adjusted such that an effective refractive index of the waveguide (105; 405) is substantially constant over temperature for a wavelength in the range from 1.5 µm to 1.6 µm, so the waveguide (105; 405) is substantially athermal.

In a first possible implementation form of the semiconductor laser according to the first aspect of the invention, the waveguide layer has a thickness in the range from about 300 nm to about 400 nm.

In a second possible implementation form of the semiconductor laser according to the first aspect or the first implementation form of the first aspect of the invention, the compensation layer comprises titanium dioxide.

In a third possible implementation form of the semiconductor laser according to the second implementation form of the first aspect of the invention, the compensation layer has a thickness (relative to the waveguide layer in the vertical direction) in the range from about 100 nm to about 250 nm, preferably in the range from about 150 nm to about 200 nm.

In a fourth possible implementation form of the first aspect of the invention, the planarising oxide layer has a thickness in the range from about 30 to about 150 nm.

In a fifth possible implementation form of the first aspect of the invention as such or any one of the first to fourth implementation form thereof, the reflector region comprises a ring resonator and/or a Bragg grating.

In a sixth possible implementation form of the first aspect of the invention as such or any one of the first to fifth implementation form thereof, the reflector region and the waveguide are implemented on a planar light wave circuit.

In a seventh possible implementation form of the sixth implementation form of the first aspect of the invention, the gain region is provided by a III-V gain chip.

In an eighth possible implementation form of the seventh possible implementation form of the first aspect of the invention, the planar light wave circuit is edge coupled to the III-V gain chip or integrated in the III-V gain chip.

In a ninth possible implementation form of the seventh possible implementation form of the first aspect of the invention, the planar light wave circuit is evanescently coupled to the III-V gain chip.

### BRIEF DESCRIPTION OF THE DRAWINGS

Further embodiments of the invention will be described with respect to the following figures, in which:
Fig. 1 shows a schematic top plan view of an athermal laser according to an embodiment;
Fig. 2 shows a schematic cross-section through an athermal laser according to an embodiment along the line A shown in Fig. 1;
Fig. 3 shows a diagram illustrating the dependence of the resonance wavelength shift per degree Kelvin on the thickness of a compensation layer of a waveguide of an athermal laser according to an embodiment; and
Fig. 4 shows a schematic top plan view of an athermal laser according to an embodiment.

### DETAILED DESCRIPTION OF EMBODIMENTS

In the following detailed description, reference is made to the accompanying drawings, which form a part of the disclosure, and in which are shown, by way of illustration, specific aspects in which the disclosure may be practiced. It is understood that other aspects may be utilized and structural or logical changes may be made without departing from the scope of the present disclosure. The following detailed description, therefore, is not to be taken in a limiting sense, and the scope of the present disclosure is defined by the appended claims.

It is understood that a disclosure in connection with a described method may also hold true for a corresponding device or system configured to perform the method and vice versa. For example, if a specific method step is described, a corresponding device may include a unit to perform the described method step, even if such unit is not explicitly described or illustrated in the figures. Further, it is understood that the features of the various exemplary aspects described herein may be combined with each other, unless specifically noted otherwise.

The devices described herein may be implemented for producing integrated optical chips. The described devices may include integrated circuits and may be manufactured according to various technologies. For example, the circuits may include logic integrated circuits, analog integrated circuits, mixed signal integrated circuits, optical circuits and/or memory circuits.

In the following description devices using waveguides are described. A waveguide is a physical structure that guides electromagnetic waves, in particular in the optical spectrum. Common types of waveguides include optical fiber and rectangular waveguides. Waveguides can be classified according to their geometry, e.g. as planar, strip, or fiber waveguides, mode structure, e.g. as single-mode or multi-mode, refractive index distribution, e.g. step or gradient index distribution and material, e.g. glass, polymer or semiconductor.

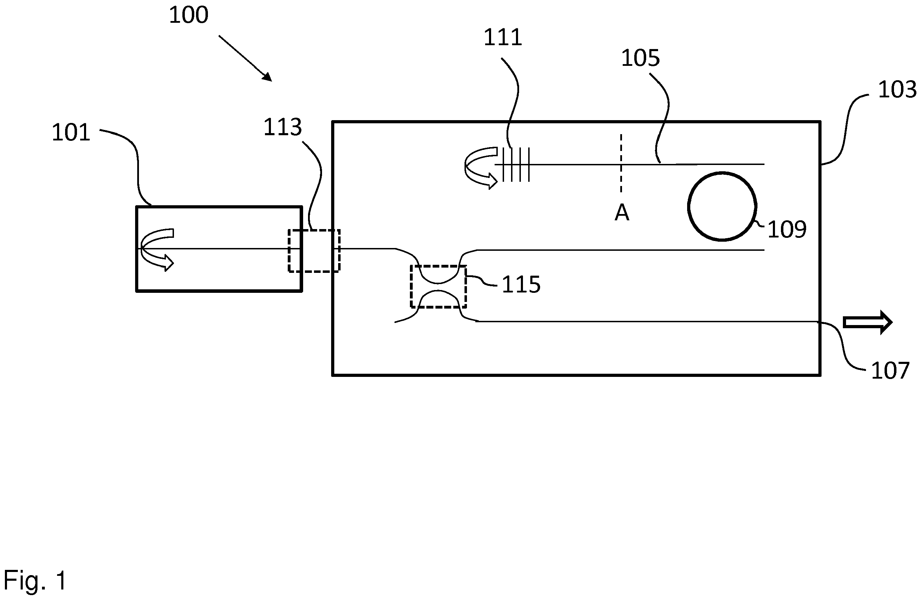

Figure 1 shows a schematic top plan view of a substantially temperature insensitive or athermal laser 100 according to an embodiment. In an embodiment, the athermal laser 100 is implemented as a semiconductor laser.

The athermal laser 100 comprises an active gain region 101 for generating laser radiation. In an embodiment, the gain region 101 is provided by a III-V gain chip. As indicated by the arrow shown in the gain region 101 of the athermal laser embodiment 100 of figure 1, the gain region 101 can comprise a high reflection facet for reflecting laser radiation generated in the gain region 101.

Furthermore, the athermal laser 100 comprises a passive reflector region 103 for reflecting the laser radiation generated in the gain region 101. In an embodiment, the reflector region 103 can be implemented on a planar light wave circuit.

In an embodiment, the laser radiation generated in the gain region 101 can be coupled into the reflector region 103 via a first coupling region 113. In an embodiment, the reflector region 103, in the form of a planar light wave circuit, is edge coupled to the gain region 101, in the form of a III-V gain chip.

Furthermore, the athermal laser 100 comprises a waveguide 105 for guiding the laser radiation generated in the gain region 101 to the reflector region 103 and/or within the reflector region 103 and for guiding the laser radiation reflected in the reflector region 103 to the gain region 101. In the embodiment shown in figure 1 the waveguide 105 is substantially part of the reflector region 103, in particular the portion of the reflector region 103 including a ring resonator 109 and a distributed Bragg reflector 111, as will be described in more detail below. The person skilled in the art will appreciate, however, that the waveguide 105 could be implemented advantageously also in other parts of the athermal laser 100 for guiding the laser radiation.

The gain region 101, the reflector region 103 and the waveguide 105 define a resonating cavity of the athermal laser 100. In an embodiment, the reflector region 103 comprises a ring resonator 109 and a Bragg grating or distributed Bragg reflector 111 such that a resonating cavity or Fabry-Perot laser cavity is defined between the high-reflection facet of the gain region 101 and the distributed Bragg reflector 111. As the person skilled in the art will appreciate, the lasing wavelength of the athermal laser 100 shown in figure 1 is essentially determined by the reflection characteristics of the ring resonator 109 and the distributed Bragg reflector 111. In an embodiment, one of the multiple transmission peaks of the ring resonator 109 is selected by using a stopband of the distributed Bragg reflector 111.

In the embodiment shown in figure 1, laser radiation is extracted from the resonating cavity defined by the gain region 101, the reflector region 103 and the waveguide 105 by means of a second coupling region 115 located along a portion of the waveguide 105 between the gain region 101 and the ring resonator 109. In an embodiment, the second coupling region 115 is optically connected to an output facet 107 of the athermal laser 100 via a further portion of the waveguide 105.

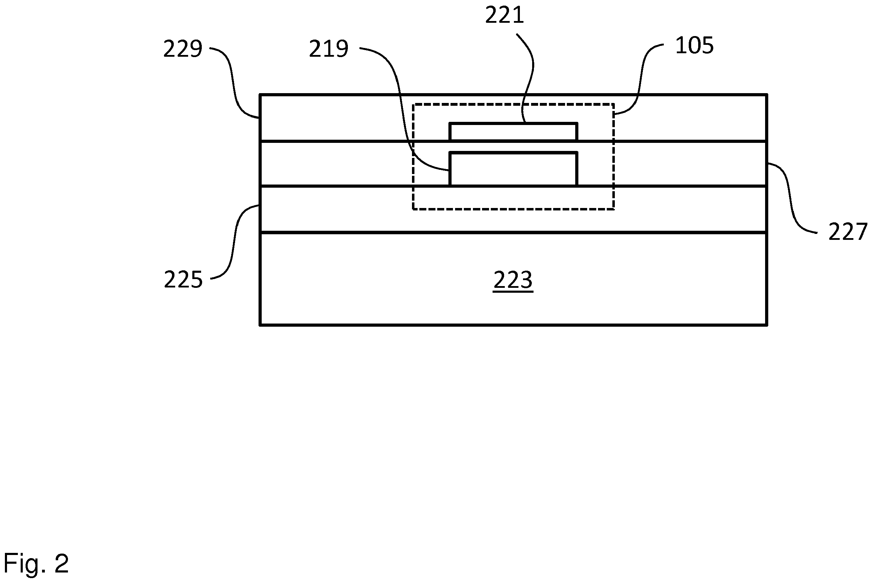

Figure 2 shows a schematic cross-section through the athermal laser embodiment 100 shown in figure 1 along the line A. As will be described in more detail below, in the embodiment shown in figure 2 the waveguide 105 is essentially defined by a waveguide layer 219 as well as a compensation layer 221 resulting in a substantially athermal waveguide 105 and, thus, a substantially athermal reflector region 103.

In an embodiment, the waveguide 105 defined by the waveguide layer 219 and the compensation layer 221 is arranged on top of a silicon wafer 223. In an embodiment, the waveguide layer 219 is separated from the silicon wafer 223 by means of an underclad oxide layer 225. In an embodiment, the waveguide layer 219 is separated from the compensation layer 221 by a portion of a planarising oxide layer 227 that is deposited on top of the underclad oxide layer 225. In an embodiment, an overclad oxide layer 229 is deposited on top of the compensation layer 221 and the planarising oxide layer 227. In an embodiment, the planarising oxide layer 227 has a thickness between the waveguide layer 219 and the compensation layer 221 in the range from about 30 to about 150 nm. In an embodiment, the arrangement of layers shown in the embodiment of figure 2 is compatible with CMOS processing.

In an embodiment, the compensation layer 221 of the waveguide 105 comprises a material with a refractive index in the range from about 1.8 to about 2.5 and a negative temperature coefficient in the range from -0.5 x 10⁻⁴ to -2 x 10⁻⁴ per °C. In an embodiment, a waveguide 105 with these properties is provided by a waveguide layer 219 comprising silicon nitride (SiN) and/or a compensation layer 221 comprising titanium dioxide (TiO₂).

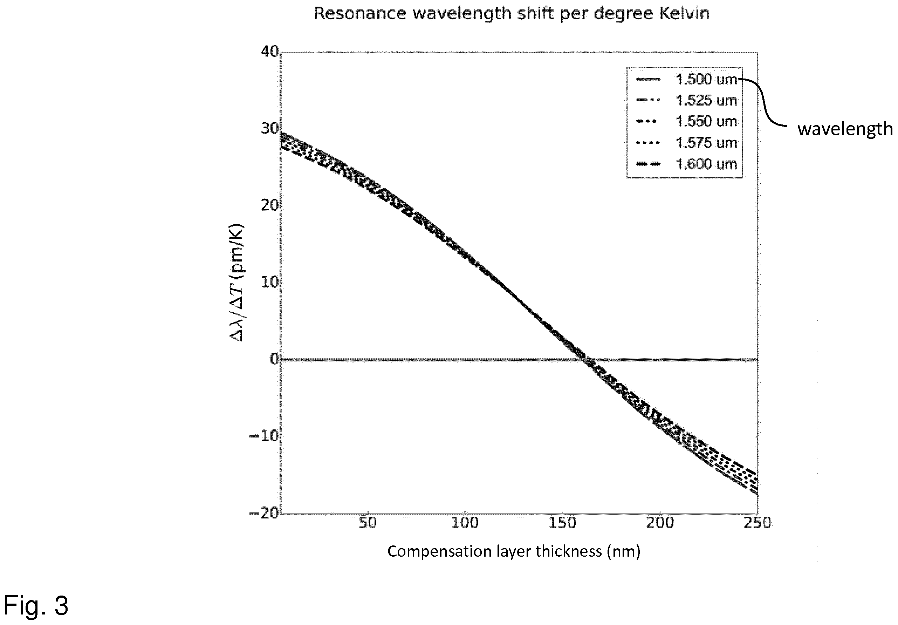

Figure 3 shows a diagram illustrating the dependence of the resonance wavelength shift per degree Kelvin of an athermal laser 100 according to an embodiment on the thickness of a titanium oxide compensation layer 221 arranged on top of a silicon nitride waveguide layer 219 for five different wavelengths (namely wavelengths in the range from 1.5 µm to 1.6 µm). In this example, the silicon nitride waveguide layer 219 has a thickness of about 400 nm and a width of about 800 nm, while the titanium dioxide layer has a width of 3 µm. In this example, for the silicon nitride waveguide layer 219 the refractive index at 1550 nm is about 2,005 and the temperature coefficient is about 5 x 10⁻⁵ per °C. In this example, for the titanium dioxide compensation layer 221 the refractive index at 1550 nm is about 2,2 and the temperature coefficient is about -1 x 10⁻⁴ per °C.

As can be taken from figure 3, a thickness of the (titanium dioxide) compensation layer 221 (relative to the waveguide layer 207 in the vertical direction) in the range from about 100 nm to about 250 nm, preferably in the range from about 150 nm to about 200 nm provides for a substantially athermal waveguide 105 and, thus, for a substantially athermal laser 100. In a further embodiment, the thickness of the compensation layer 221 is such that the effective index n of the waveguide 105 is substantially constant over temperature.

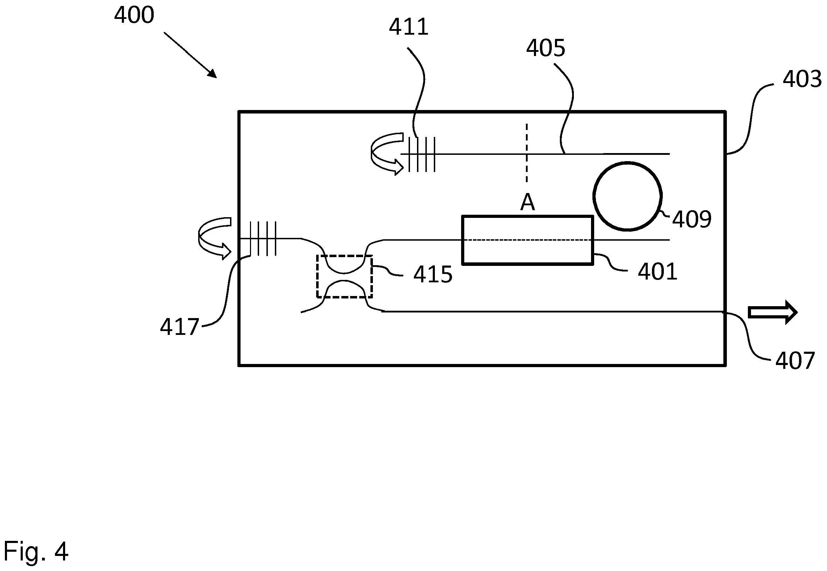

The arrangement of layers, in particular the waveguide layer 219 and the compensation layer 221, shown in figure 2 can be implemented as an athermal waveguide 405 in a further embodiment of an athermal laser 400 shown in figure 4. In order to avoid unnecessary repetitions the below description of the athermal laser embodiment 400 of figure 4 will focus on the differences to the athermal laser embodiment 100 of figure 1. Save to the different first digit (i.e. "4" instead of "1"), the same elements shown in figure 4 and figure 1 have been identified by the same reference signs. For a detailed discussion of these same elements reference is made to the above description of the athermal laser embodiment 100 of figure 1.

The main difference between the athermal laser embodiment 400 shown in figure 4 and the athermal laser embodiment 100 shown in figure 1 is that in the laser embodiment 400 the gain region 401 is evanescently coupled to the reflector region 403. More specifically, the gain region 401 is arranged, for instance, on top of the reflector region 403 such that laser radition generated in the gain region 401 can be evanescently coupled into the reflector region 403. In the embodiment shown in figure 4, a further distributed Bragg reflector 417 can be provided at one end of the reflector region 403 to define a resonating cavity. In a further embodiment, another ring resonator (not shown in figure 4) can be combinded with the distributed Bragg reflector 417.

The devices described herein may be implemented as optical circuit within a chip or an integrated circuit or an application specific integrated circuit (ASIC). The invention can be implemented in digital and/or analogue electronic and optical circuitry.

While a particular feature or aspect of the disclosure may have been disclosed with respect to only one of several implementations or embodiments, such feature or aspect may be combined with one or more other features or aspects of the other implementations or embodiments as may be desired and advantageous for any given or particular application. Furthermore, to the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

## Claims

1. A semiconductor laser (100; 400), comprising:
a gain region (101; 401)for generating laser radiation;
a reflector region (103; 403) for reflecting the laser radiation generated in the gain region (101; 401), and
a waveguide (105; 405) for guiding the laser radiation generated in the gain region (101; 401) to the reflector region (103; 403) and for guiding the laser radiation reflected in the reflector region (103; 403) to the gain region (101; 401), wherein the gain region (101; 401), the reflector region (103; 403) and the waveguide (105; 405) define a resonating cavity of the semiconductor laser (100; 400), wherein the waveguide (105; 405) comprises a waveguide layer (219) and a compensation layer (221) arranged above the waveguide layer (219), wherein the semiconductor laser further comprising a planarising oxide layer (227) arranged between the waveguide layer (219) and the compensation layer (221), wherein the compensation layer (221) comprises a material with a refractive index in the range from about 1.8 to about 2.5 and a negative temperature coefficient in the range from -0.5 x 10⁻⁴ to -2 x 10⁻⁴ per °C, wherein the waveguide layer (219) comprises silicon nitride, wherein a thickness of the compensation layer (221) is adjusted such that an effective refractive index of the waveguide (105; 405) is substantially constant over temperature for a wavelength in the range from 1.5 µm to 1.6 µm, so that the waveguide (105; 405) is substantially athermal.

2. The semiconductor laser (100; 400) of claim 1, wherein the waveguide layer (219) has a thickness in the range from about 300 nm to about 400 nm.

3. The semiconductor laser (100; 400) of claim 1 or 2, wherein the compensation layer (221) comprises titanium dioxide.

4. The semiconductor laser (100; 400) of claim 3, wherein the compensation layer (221) has a thickness in the range from about 100 nm to about 250 nm, preferably in the range from about 150 nm to about 200 nm.

5. The semiconductor laser (100; 400) of claim 1, wherein the planarising oxide layer (227) has a thickness in the range from about 30 to about 150 nm.

6. The semiconductor laser (100; 400) of any one of the preceding claims, wherein the reflector region (103; 403) comprises a ring resonator (109; 409) and/or a Bragg grating (111; 411).

7. The semiconductor laser (100; 400) of any one of the preceding claims, wherein the reflector region (103; 403) and the waveguide (105; 405) are implemented on a planar light wave circuit.

8. The semiconductor laser (100; 400) of claim 7, wherein the gain region (101; 401) is provided by a III-V gain chip.

9. The semiconductor laser (100) of claim 8, wherein the planar light wave circuit is edge coupled to the III-V gain chip or integrated in the III-V gain chip.

10. The semiconductor laser (400) of claim 8, wherein the planar light wave circuit is evanescently coupled to the III-V gain chip.

## Patentansprüche

1. Halbleiterlaser (100; 400), umfassend:
eine Verstärkungszone (101; 401) zum Erzeugen von Laserstrahlung;
eine Reflektorzone (103; 403) zum Reflektieren der in der Verstärkungszone (101; 401) erzeugten Laserstrahlung, und
einen Wellenleiter (105; 405) zum Leiten der in der Verstärkungszone (101; 401) erzeugten Laserstrahlung zu der Reflektorzone (103; 403) und zum Leiten der in der Reflektorzone (103; 403) reflektierten Laserstrahlung zu der Verstärkungszone (101; 401), wobei die Verstärkungszone (101; 401), die Reflektorzone (103; 403) und der Wellenleiter (105; 405) einen Hohlraumresonator des Halbleiterlasers (100; 400) definieren, wobei der Wellenleiter (105; 405) eine Wellenleiterschicht (219) und eine Kompensationsschicht (221) umfasst, die über der Wellenleiterschicht (219) angeordnet ist, wobei der Halbleiterlaser ferner eine planarisierende Oxidschicht (227) umfasst, die zwischen der Wellenleiterschicht (219) und der Kompensationsschicht (221) angeordnet ist, wobei die Kompensationsschicht (221) ein Material mit einem Brechungsindex in dem Bereich von ca. 1,8 bis 2,5 und einen negativen Temperaturkoeffizienten in dem Bereich von -0,5 x 10⁻⁴ bis -2 x 10⁻⁴ pro °C umfasst, wobei die Wellenleiterschicht (219) Siliziumnitrid umfasst, wobei eine Dicke der Kompensationsschicht (221) derart angepasst ist, dass ein tatsächlicher Brechungsindex des Wellenleiters (105, 405) für eine Wellenlänge in dem Bereich von 1,5 µm bis 1,6 µm im Temperaturverlauf im Wesentlichen konstant ist, sodass der Wellenleiter (105; 405) im Wesentlichen athermisch ist.

2. Halbleiterlaser (100; 400) nach Anspruch 1, wobei die Wellenleiterschicht (219) eine Dicke in dem Bereich von ca. 300 nm bis ca. 400 nm aufweist.

3. Halbleiterlaser (100; 400) nach Anspruch 1 oder 2, wobei die Kompensationsschicht (221) Titandioxid umfasst.

4. Halbleiterlaser (100; 400) nach Anspruch 3, wobei die Kompensationsschicht (221) eine Dicke in dem Bereich von ca. 100 nm bis ca. 250 nm, vorzugsweise in dem Bereich von ca. 150 nm bis ca. 200 nm aufweist.

5. Halbleiterlaser (100; 400) nach Anspruch 1, wobei die planarisierende Oxidschicht (227) eine Dicke in dem Bereich von ca. 30 bis ca. 150 nm aufweist.

6. Halbleiterlaser (100; 400) nach einem der vorhergehenden Ansprüche, wobei die Reflektorzone (103; 403) einen Ringresonator (109; 409) und/oder ein Bragg-Gitter (111; 411) aufweist.

7. Halbleiterlaser (100; 400) nach einem der vorhergehenden Ansprüche, wobei die Reflektorzone (103; 403) und der Wellenleiter (105; 405) in einer planaren Lichtwellenleiterschaltung implementiert sind.

8. Halbleiterlaser (100; 400) nach Anspruch 7, wobei die Verstärkungszone (101; 401) durch einen III-V-Verstärkungschip bereitgestellt ist.

9. Halbleiterlaser (100) nach Anspruch 8, wobei die planare Lichtwellenleiterschaltung mit dem III-V-Verstärkungschip an der Kante gekoppelt oder in den III-V-Verstärkungschip integriert ist.

10. Halbleiterlaser (400) nach Anspruch 8, wobei die planare Lichtwellenleiterschaltung mit dem III-V-Verstärkungschip evaneszent gekoppelt ist.

## Revendications

1. Laser à semi-conducteur (100 ; 400), comprenant :
une région de gain (101 ; 401) pour générer un rayonnement laser ;
une région de réflecteur (103 ; 403) pour réfléchir le rayonnement laser généré dans la région de gain (101 ; 401), et
un guide d'ondes (105 ; 405) pour guider le rayonnement laser généré dans la région de gain (101 401) vers la région de réflecteur (103; 403) et pour guider le rayonnement laser réfléchi dans la région de réflecteur (103 ; 403) vers la région de gain (101 ; 401), la région de gain (101 ; 401), la région de réflecteur (103 ; 403) et le guide d'ondes (105 ; 405) définissant une cavité résonante du laser semi-conducteur (100 ; 400), le guide d'ondes (105 ; 405) comprenant une couche de guide d'ondes (219) et une couche de compensation (221) agencées au-dessus de la couche de guide d'ondes (219), le laser à semi-conducteur comprenant en outre une couche d'oxyde de planarisation (227) agencée entre la couche de guide d'ondes (219) et la couche de compensation (221), la couche de compensation (221) comprenant un matériau ayant un indice de réfraction dans la gamme allant d'environ 1,8 à environ 2,5 et un coefficient de température négatif dans la plage de -0,5 x 10⁻⁴ à -2 x 10⁻⁴ par °C, la couche de guide d'ondes (219) comprenant du nitrure de silicium, une épaisseur de la couche de compensation (221) étant ajustée de telle sorte qu'un indice de réfraction effectif du guide d'ondes (105 ; 405) est sensiblement constant selon la température pour une longueur d'onde dans la gamme de 1,5 µm à 1,6 µm, de sorte que le guide d'ondes (105 ; 405) est sensiblement athermique.

2. Laser à semi-conducteur (100; 400) selon la revendication 1, la couche de guide d'ondes (219) ayant une épaisseur dans la gamme d'environ 300 nm à environ 400 nm.

3. Laser à semi-conducteur (100; 400) selon la revendication 1 ou 2, la couche de compensation (221) comprenant du dioxyde de titane.

4. Laser à semi-conducteur (100 ; 400) selon la revendication 3, la couche de compensation (221) ayant une épaisseur dans la gamme d'environ 100 nm à environ 250 nm, de préférence dans la gamme d'environ 150 nm à environ 200 nm.

5. Laser à semi-conducteur (100 ; 400) selon la revendication 1, la couche d'oxyde de planarisation (227) ayant une épaisseur dans la gamme d'environ 30 à environ 150 nm.

6. Laser à semi-conducteur (100; 400) selon l'une quelconque des revendications précédentes, la région de réflecteur (103; 403) comprenant un résonateur en anneau (109 ; 409) et/ou un réseau de Bragg (111 ; 411).

7. Laser à semi-conducteur (100; 400) selon l'une quelconque des revendications précédentes, la région de réflecteur (103 ; 403) et le guide d'ondes (105 ; 405) étant réalisés sur un circuit d'onde de lumière planaire.

8. Laser à semi-conducteur (100 ; 400) selon la revendication 7, la région de gain (101 ; 401) étant fournie par une puce de gain III-V.

9. Laser à semi-conducteur (100) selon la revendication 8, le circuit d'onde de lumière planaire étant couplé au bord de la puce de gain III-V ou intégré dans la puce de gain III-V.

10. Laser à semi-conducteur (400) selon la revendication 8, le circuit d'onde de lumière planaire étant couplé de manière évanescente à la puce de gain III-V.
